# EUROPEAN PATENT APPLICATION

(11) **EP 4 549 984 A1**
(43) Date of publication of application: **07.05.2025**
(21) Application number: 23209800.4
(22) Date of filing: 14.11.2023
(51) Int. Cl.: G01R 33/561, G01R 33/563, G01R 33/48, G01R 33/56

(54) **MAGNETIC RESONANCE ANGIOGRAPHY IMAGING METHOD AND SYSTEM**

(30) Priority: 03.11.2023 US 202363547164 P
(71) Applicant: Koninklijke Philips N.V., 5656 AG Eindhoven (NL)
(72) Inventor: JOHNSON, Brian David, Eindhoven (NL); GANJI, Sandeep K, Eindhoven (NL)
(74) Representative: Philips Intellectual Property & Standards

(57) **Abstract**

The invention relates to a method of MR imaging of at least a part of a patient's body (10) placed in an examination volume of an MR system (1). It is an object of the invention to provide an improved rapid gradient echo imaging technique with the ability to obtain angiographic information. The method of the invention comprises the following steps: subjecting the body part to a magnetization preparation RF pulse (MP); after a preparation delay (TD), subjecting the body part to a gradient echo imaging sequence comprising a series of RF excitations (EP), wherein phase-encoding (PE) and refocusing gradients (RO) as well as at least one bipolar pair of velocity-encoding gradients (VE) are applied in a repetition time interval (TR) between successive RF excitations (EP) to sample a pre-defined region of k-space and to generate a gradient echo in each repetition time interval (TR); acquiring echo signals from the body part; reconstructing a morphological MR image of the body part from the acquired echo signals; and deriving phase-contrast angiographic information from the phase imposed on the echo signals by the velocity-encoding gradients (VE). Moreover, the invention relates to an MR system (1) and to a computer program.

## Description

### FIELD OF THE INVENTION

The invention relates to the field of magnetic resonance (MR) imaging. It concerns a method of MR imaging of at least a part of a patient's body placed in the examination volume of an MR system. The invention also relates to an MR system and to a computer program to be run on an MR system.

### BACKGROUND OF THE INVENTION

Image-forming MR methods which utilize the interaction between magnetic fields and nuclear spins in order to form two-dimensional or three-dimensional images are widely used nowadays, notably in the field of medical diagnostics, because for the imaging of soft tissue they are superior to other imaging methods in many respects, do not require ionizing radiation and are usually not invasive.

Gradient echo imaging is widely used in MR imaging for numerous applications ranging from angiography to perfusion to functional MR imaging. Compared with spin-echo techniques, the very short repetition times of gradient echo methods enable very fast 2D and 3D imaging.

So-called rapid gradient echo sequences (RAGE) consist of a series of RF excitation pulses having a certain flip angle, wherein phase-encoding and refocusing magnetic field gradients are applied in a repetition time (TR) interval between successive RF excitations to sample a pre-defined region of k-space and to generate a gradient echo in each repetition time interval. The echo time (TE) is the time from each RF excitation pulse to the formation of the subsequent gradient echo.

In order to enhance the intrinsic contrast of gradient echo imaging, magnetization preparation schemes are often used. Rapid gradient echo imaging with magnetization preparation is commonly referred to as MP-RAGE. The magnetization preparation used in MP-RAGE can be performed, e.g., by applying a spatially non-selective inversion RF pulse to obtain a T₁-weighted contrast. The magnetization preparation RF pulse precedes the actual rapid gradient echo sequence with a temporal delay between the magnetization preparation RF pulse and the beginning of the gradient echo readout. The delay (as well as the flip angle of the RF excitation pulses) determines the image contrast.

In particular, 3D MP-RAGE provides excellent tissue contrast, high spatial resolution, and full Ti-weighted coverage in, e.g., imaging of the brain in a clinically feasible scan time. MP-RAGE is one of the most widely used sequences in clinical practice.

Phase-contrast (PC) MR imaging is a specialized technique that is primarily used to visualize and quantify the flow of fluids within the body, such as blood flow in blood vessels or cerebrospinal fluid flow in the central nervous system. This technique is particularly valuable in diagnosing and studying vascular and cardiovascular diseases, as well as certain neurological conditions.

PC MR imaging takes advantage of the phase information of the magnetic resonance signal. The phase information encodes details about the position of the nuclear spins in the tissue and their movement. Magnetic resonance signals are acquired in PC MR imaging with a bipolar pair of velocity-encoding magnetic field gradients applied across the region of interest, such as a blood vessel or a region of cerebrospinal fluid. The bipolar gradient pair causes the phase of the magnetic resonance signal to shift in proportion to the velocity of the moving fluid. A resulting phase-contrast image contains information about the velocity and direction of fluid flow within the imaged region. The amount of phase shift is directly proportional to the velocity of the flowing fluid, and the direction of the shift indicates the direction of flow. By knowing the specific imaging parameters and calibration factors, it's possible to quantitatively measure flow velocities.

Typically, two sets of MR image data are acquired in known PC MR imaging schemes. One set is acquired with the bipolar velocity-encoding gradient applied across the area of interest. The other set is acquired without the bipolar velocity-encoding gradient, serving as a reference or baseline. The phase information from this reference data set is subtracted from the phase information of the image data set acquired with application of the velocity-encoding bipolar gradient. This subtraction process highlights the phase shifts caused by the fluid flow.

Phase-contrast angiography (PCA) holds the potential to be a comprehensive vascular MR imaging technique based on the explained phase-contrast scheme that provides vascular images without the use of gadolinium-based contrast agents. However, PCA imaging has not found widespread application in clinical practice due to its particularly long imaging times. On the other hand, recent advances in acceleration techniques, like compressed sensing and deep learning-based reconstruction, can drastically reduce the required scan time.

### SUMMARY OF THE INVENTION

Against this background it is an object of the invention to provide an improved rapid gradient echo imaging technique with the ability to obtain angiographic information.

In accordance with the invention, a method of MR imaging of at least a part of a patient's body placed in an examination volume of an MR system is disclosed. The method comprises the following steps:
- subjecting the body part to a magnetization preparation RF pulse;
- after a preparation delay, subjecting the body part to a gradient echo imaging sequence comprising a series of RF excitations, wherein phase-encoding and refocusing gradients as well as at least one bipolar pair of velocity-encoding gradients are applied in a repetition time interval between successive RF excitations to sample a pre-defined region of k-space and to generate a gradient echo in each repetition time interval;

- acquiring echo signals from the body part;
- reconstructing a morphological MR image of the body part from the acquired echo signals; and
- deriving phase-contrast angiographic information from the phase imposed on the echo signals by the velocity-encoding gradients.

According to the invention, a conventional MP-RAGE imaging sequence is combined with a PC imaging scheme. To this end, the at least one bipolar pair of velocity-encoding gradients is incorporated into each TR interval which imposes a velocity-dependent phase on the echo signals. This enables a two-fold evaluation of the acquired echo signals. A morphological MR image is reconstructed like in conventional MP-RAGE imaging and, additionally, phase-contrast angiographic information (automatically co-registered with the morphological MR image) is obtained by evaluating the phase of the echo signals.

The term morphological image refers to an image that primarily provides information about the shape, structure, and anatomy of the imaged body part. Such images provide a contrast between different types of tissues based on their inherent physical properties (such as T₁, T₂, proton density etc.). A morphological MR image is essential for visualizing the internal structures of the body part.

The term phase-contrast angiographic information refers to information related to blood flow within blood vessels contained in the imaged anatomy. This includes information about the direction and velocity of blood flow, which can be used for evaluating vascular anatomy, identifying stenoses and detecting different types of blood flow abnormalities. In neuroimaging, the phase-contrast angiographic information enables the assessment of cerebral blood flow and conditions like arteriovenous malformations (AVMs) or aneurysms.

The invention thus enables capturing more anatomical, physiological, and functional data to improve diagnostic utility. The simultaneous MP-RAGE and PCA acquisition provided by the invention combines the benefits of both techniques in a single acquisition in a clinically feasible scan time.

In an embodiment, the magnetization preparation RF pulse is a spatially non-selective inversion pulse. In this way, both a (3D) Ti-weighted morphological MR image and neurovascular information can be obtained. Cerebral vasculature and blood flow are altered in a variety of diseases. The phase-contrast angiographic information can effectively be used as a lumenographic imaging tool for the identification of aneurysms, arteriovenous malformations, and vascular stenoses in the cerebrovascular system.

In another embodiment, the derivation of phase-contrast angiographic information includes the reconstruction of a phase-contrast angiographic MR image from the acquired echo signals. The image contrast of the phase-contrast angiographic MR image is determined by the flow velocity at the different image positions. A weighted subtraction of the morphological MR image and the phase-contrast angiographic MR image can be computed to obtain an MR image of the body part with black-blood appearance without the need of co-registration of different images. With the weighted subtraction, the image intensity in the lumen of the blood vessels is removed where blood flow occurs. This is useful, e.g., for vessel wall imaging and for improving post-contrast brain metastasis diagnostic confidence. The invention thus provides an advantageous imaging option due to its non-invasive nature (no contrast agent), ability to image vessels with complex geometry, high spatial resolution, and ability to correlate the morphological image and the angiographic image information.

The approach of the invention can be further extended to acquire time resolved 3D flow imaging to allow for morphological and functional 4D neurovascular flow analysis.

In yet another embodiment, the gradient echo imaging sequence performs undersampling of k-space to accelerate the sampling of the pre-defined region. K-space undersampling allows for faster image acquisition while maintaining acceptable image quality. This technique is crucial for achieving a clinically feasible scan time. K-space undersampling involves acquiring only a fraction of the total k-space data points necessary for a full, high-resolution image in accordance with Nyquist's theorem. This is typically achieved by intentionally skipping or reducing the number of phase-encodings. Diagnostically useful and artefact-free images can be obtained from the undersampled MR signal data using advanced reconstruction algorithms.

The morphological MR image and/or the phase-contrast angiographic MR image can be reconstructed from undersampled echo signal data using, e.g., compressed sensing, deep learning-based reconstruction, or other advanced reconstruction techniques. Compressed sensing is a mathematical framework that exploits the sparsity or compressibility of MR images in certain domains (e.g., wavelet domain) to enable high-quality MR image reconstruction from significantly undersampled k-space data. Deep-learning reconstruction techniques use artificial neural networks, particularly convolutional neural networks (CNNs), to reconstruct MR images from undersampled k-space data.

The morphological MR image and/or the phase-contrast angiographic MR image may also be acquired and reconstructed using parallel imaging. In parallel imaging, the magnetic resonance signals are acquired simultaneously via multiple receiving coils or antennae having different spatial sensitivity profiles across the imaged region. By taking these profiles into account, e.g. SENSE (as one of the most widely used parallel imaging techniques) can unambiguously reconstruct the MR image even from significantly undersampled MR signal data. GRAPPA is another popular parallel imaging technique. It uses auto-calibration lines within k-space to estimate the missing data points in the undersampled MR signal data. These estimates are used to reconstruct the full MR image. The primary advantage of parallel imaging is its ability to acquire MR images much faster than traditional MR imaging techniques.

The method of the invention described thus far can be carried out by means of an MR system including at least one main magnet coil for generating an essentially uniform, static magnetic field Bo within an examination volume, a number of gradient coils for generating switched magnetic field gradients in different spatial directions within the examination volume, at least one body RF coil for generating RF pulses within the examination volume and/or for receiving MR signals from a body of a patient positioned in the examination volume, a control unit for controlling the temporal succession of RF pulses and switched magnetic field gradients, and a reconstruction unit for reconstructing MR images from the received MR signals. The method of the invention can be implemented by a corresponding programming of the reconstruction unit and/or the control unit of the MR system.

The method of the invention can be advantageously carried out on most MR systems in clinical use at present. To this end it is merely necessary to utilize a computer program by which the MR system is controlled such that it performs the above-explained method steps of the invention. The computer program may be present either on a data carrier or be present in a data network so as to be downloaded for installation in the control unit of the MR system.

### BRIEF DESCRIPTION OF THE DRAWINGS

The enclosed drawings disclose preferred embodiments of the present invention. It should be understood, however, that the drawings are designed for the purpose of illustration only and not as a definition of the limits of the invention. In the drawings:
Fig. 1 shows an MR system for carrying out the method of the invention;
Fig. 2 shows a schematic (simplified) pulse sequence diagram of an imaging sequence according to the invention;
Fig. 3 shows exemplary brain images to illustrate the capabilities of the method of the invention;
Fig. 4 shows exemplary angiographic images to illustrate the capabilities of the method of the invention.

### DETAILED DESCRIPTION OF THE EMBODIMENTS

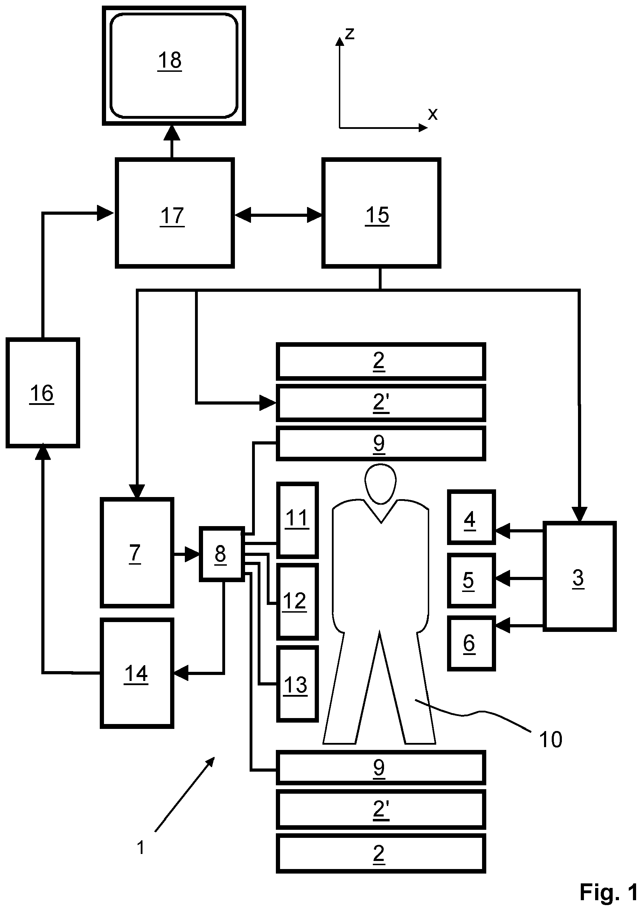

With reference to Fig. 1, an MR system 1 is shown as a block diagram. The system comprises superconducting or resistive main magnet coils 2 such that a substantially uniform, temporally constant main magnetic field Bo is created along a z-axis through an examination volume. The device further comprises a set of (1^{st}, 2^{nd}, and - where applicable - 3^{rd} order) shimming coils 2', wherein the current flow through the individual shimming coils of the set 2' is controllable for the purpose of minimizing Bo deviations within the examination volume.

A magnetic resonance generation and manipulation system applies a series of RF pulses and switched magnetic field gradients to invert, excite, refocus, and/or spatially and otherwise encode the magnetic resonance to perform MR imaging.

More specifically, a gradient pulse amplifier 3 applies current pulses to selected ones of whole-body gradient coils 4, 5 and 6 along x, y and z-axes of the examination volume. A digital RF frequency transmitter 7 transmits RF pulses or pulse packets, via a send/receive switch 8, to a RF body coil 9 to transmit RF pulses into the examination volume. A typical MR imaging sequence is composed of a packet of RF pulse segments of short duration which, together with any applied magnetic field gradients, achieve a selected manipulation of magnetic resonance. The RF pulses are used in particular to select a portion of a body 10 positioned in the examination volume. The MR signals are also picked up by the RF body coil 9.

For generation of MR images of limited regions of the body 10, a set of local RF array coils 11, 12, 13 are placed contiguous to the region selected for imaging. The array coils 11, 12, 13 can be used to receive MR signals induced by transmissions of the RF body coil.

The resultant MR signals are picked up by the RF body coil 9 and/or by the RF array coils 11, 12, 13 and demodulated by a receiver 14 preferably including a preamplifier (not shown). The receiver 14 is connected to the RF coils 9, 11, 12 and 13 via the send/receive switch 8.

A host computer 15 controls the shimming coils 2' as well as the gradient pulse amplifier 3 and the transmitter 7 to generate the imaging sequences of the invention. For the selected sequence, the receiver 14 receives a single or a plurality of MR data lines in rapid succession following each RF excitation. A data acquisition system 16 performs analog-to-digital conversion of the received signals and converts each MR data line to a digital format suitable for further processing. In modern MR systems the data acquisition system 16 is a separate computer which is specialized in acquisition of raw image data. Ultimately, the digital raw image data are reconstructed into an image representation by a reconstruction processor 17 which applies a Fourier transform or other appropriate reconstruction algorithms, such as SENSE or GRAPPA. The MR image may represent a planar slice through the patient, an array of parallel planar slices, a 3D volume, or the like. The image is then stored in an image memory where it may be accessed for converting slices, projections, or other portions of the image representation into appropriate format for visualization, for example via a video monitor 18 which provides a man-readable display of the resultant MR image.

The host computer 15 and the reconstruction processor 17 are configured, by corresponding programming, to perform the method of the invention described herein above and in the following.

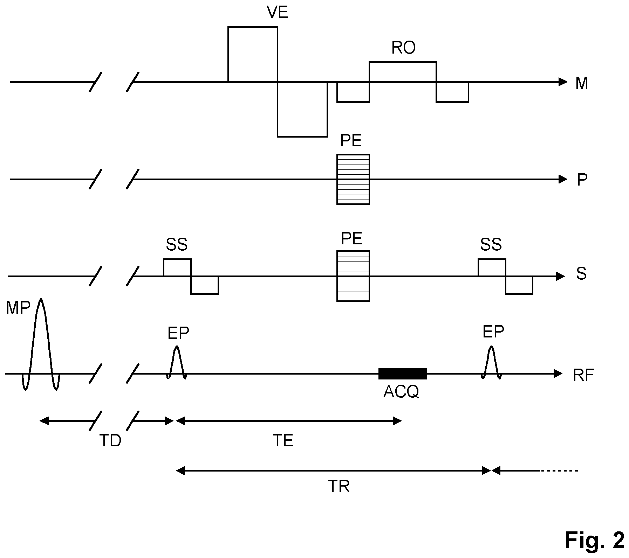

According to the invention, a (3D) MP-RAGE imaging sequence combined with velocity-encoding bipolar gradient pairs is proposed. This is illustrated in the sequence diagram in Fig. 2. Fig. 2 shows switched magnetic field gradients in the frequency-encoding direction M, the phase-encoding direction P, and the slab-selection direction S, applied during one arbitrarily selected repetition time interval TR of a rapid gradient echo imaging sequence. The diagram shows the initial magnetization preparation RF pulse MP followed by the gradient echo imaging sequence after a delay time TD. Fig. 2 shows two successive excitation RF pulses EP applied in the presence of slab-selection gradients SS. Varying phase-encoding gradients are applied in directions P and S in the successive repetition time intervals TR of the gradient echo sequence to sample a pre-defined region of k-space. Refocusing and readout gradients RO are applied to generate a gradient echo in each repetition time interval TR. The gradient echo is received and digitally sampled as an echo signal during the acquisition interval ACQ. Furthermore, a bipolar pair of velocity-encoding gradients VE is applied in the repetition time interval TR to impose a phase information on the gradient echo and, consequently, on the acquired echo signal. The bipolar gradient pair VE causes the phase of the echo signal to shift in proportion to the velocity of moving nuclear spins, i.e. water protons in flowing blood. This phase information enables the derivation of phase-contrast angiographic information from the acquired echo signals, i.e. information about the velocity and direction of the blood flow within the imaged region, in addition to a morphological MR image that is reconstructed in the conventional fashion from the acquired echo signals. The illustrated imaging scheme thus combines MP-RAGE imaging with PCA. As in conventional PCA, two sets of signal data may be acquired, i.e. one set with and the other set without the bipolar velocity-encoding gradients VE to obtain a reference. The velocity-encoding bipolar gradient pair is applied in the frequency-encoding direction M in Fig. 2. However, velocity-encoding may be applied in different spatial directions, preferably in all three spatial directions M, P, S to obtain a flow velocity vector for each position in the imaged region.

The MR imaging scheme illustrated in Fig. 2 can be combined with advanced acceleration techniques that are known per se (parallel imaging, compressed sensing, deep learning-based reconstruction, etc.) to acquire the echo signal data required to obtain both a 3D Ti-weighted morphological image and neurovascular information (PCA) in a clinically feasible scan time.

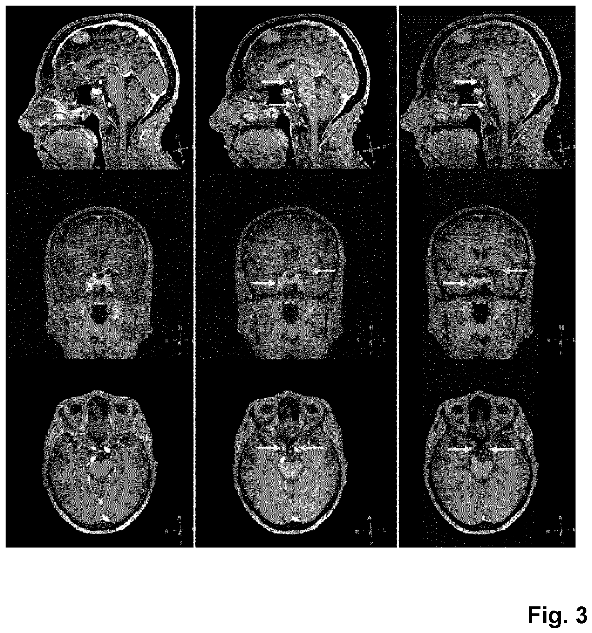

Cerebral vasculature and blood flow are altered in a variety of diseases, and PCA has been effectively used as a lumenographic imaging tool for the identification of aneurysms, arteriovenous malformations, and vascular stenoses in the cerebrovascular system. Using this lumenographic information from the PCA, the combined MP-RAGE/PCA approach of the invention can be used as a black blood imaging technique for vessel wall imaging without the need of co-registration. This is illustrated in Fig. 3. Fig. 3 shows a comparison of a conventionally acquired ADNI ("Alzheimer's Disease Neuroimaging Initiative") 3D MP-RAGE brain image (left column) to a morphological MR image acquired by the MP-RAGE/PCA method of the invention (middle column), and the result of a weighted subtraction of the morphological MR image shown in the middle column and a phase-contrast angiographic MR image derived from the phase information of the echo signals (right column). As can be seen by comparison of the middle and the right column of Fig. 3, an MR image with a black-blood appearance (right column) is obtained by the weighted digital subtraction. The arrows highlight bright vessels in the image shown in the middle column and the same vessels with black blood in the image of the right column. This shows that the approach of the invention provides an advantageous neurovascular imaging option due to its non-invasive nature, ability to image vessels with complex geometry, high spatial resolution, and ability to correlate well with other imaging features.

Fig. 3 shows a comparison of maximum intensity projection (MIP) brain images obtained by conventional PCA imaging (left column) and obtain by derivation from the phase information of the echo signals acquired in accordance with the method of the invention. As can be seen, the images are virtually identical.

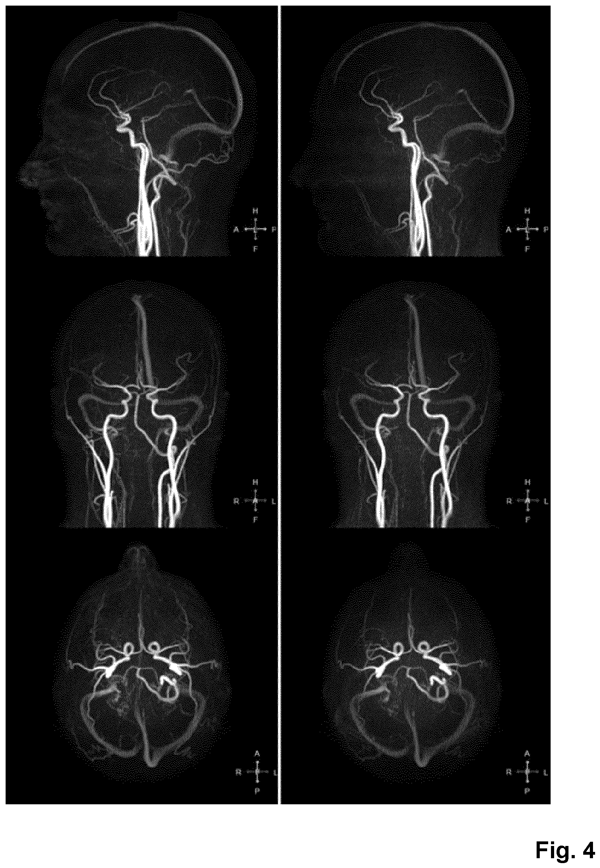

Fig. 4 shows exemplary angiographic images to illustrate the capabilities of the method of the invention.

## Claims

1. Method of MR imaging of at least a part of a patient's body (10) placed in an examination volume of an MR system (1), the method comprising the steps of:
- subjecting the body part to a magnetization preparation RF pulse (MP);
- after a preparation delay (TD), subjecting the body part to a gradient echo imaging sequence comprising a series of RF excitations (EP), wherein phase-encoding (PE) and refocusing gradients (RO) as well as at least one bipolar pair of velocity-encoding gradients (VE) are applied in a repetition time interval (TR) between successive RF excitations (EP) to sample a pre-defined region of k-space and to generate a gradient echo in each repetition time interval (TR);
- acquiring echo signals from the body part;
- reconstructing a morphological MR image of the body part from the acquired echo signals; and
- deriving phase-contrast angiographic information from the phase imposed on the echo signals by the velocity-encoding gradients (VE).

2. Method of claim 1, wherein the magnetization preparation RF pulse (MP) is a spatially non-selective inversion pulse.

3. Method of claim 1, wherein the derivation of phase-contrast angiographic information includes the reconstruction of a phase-contrast angiographic MR image from the acquired echo signals.

4. Method of claim 3, wherein a weighted subtraction of the morphological MR image and the phase-contrast angiographic MR image is computed to obtain a black-blood MR image of the body part.

5. Method of any one of claims 1-4, wherein the gradient echo imaging sequence performs undersampling of k-space to accelerate the sampling of the pre-defined region.

6. Method of claim 5, wherein the morphological MR image and/or the phase-contrast angiographic MR image are acquired and reconstructed using parallel imaging.

7. Method of claim 5 or 6, wherein the morphological MR image and/or the phase-contrast angiographic MR image are reconstructed using compressed sensing or deep learning-based reconstruction.

8. Method of any one of claims 1-7, wherein the morphological MR image is a Ti-contrast MR image.

9. MR system (1) comprising:
- at least one main magnet coil (2) for generating a uniform, steady magnetic field within an examination volume;
- a number of gradient coils (4, 5, 6) for generating switched magnetic field gradients in different spatial directions within the examination volume;
- at least one RF coil (9) for generating RF pulses within the examination volume and/or for receiving MR signals from at least a part of a patient's body (10) positioned in the examination volume;
- a control unit (15) for controlling the temporal succession of RF pulses and switched magnetic field gradients; and
- a reconstruction unit (17) for reconstructing an MR image from the received MR signals, wherein the MR system (1) is configured to perform the following steps:
- subjecting the body part to a magnetization preparation RF pulse (MP);
- after a preparation delay (TD), subjecting the body part to a gradient echo imaging sequence comprising a series of RF excitations (EP), wherein phase-encoding (PE) and refocusing gradients (RO) as well as at least one bipolar pair of velocity-encoding gradients (VE) are applied in a repetition time interval (TR) between successive RF excitations (EP) to sample a pre-defined region of k-space and to generate a gradient echo in each repetition time interval (TR);
- acquiring echo signals from the body part;
- reconstructing a morphological MR image of the body part from the acquired echo signals; and
- deriving phase-contrast angiographic information from the phase imposed on the echo signals by the velocity-encoding gradients (VE).

10. Computer program comprising instructions to be executed by a control unit (15) of an MR system (1), wherein execution of the instructions causes the MR system (1) to perform the following steps:
- generating a magnetization preparation RF pulse (MP);
- after a preparation delay, generating a gradient echo imaging sequence comprising a series of RF excitations (EP), wherein phase-encoding (PE) and refocusing gradients (RO) as well as at least one bipolar pair of velocity-encoding gradients (VE) are applied in a repetition time interval (TR) between successive RF excitations (EP) to sample a pre-defined region of k-space and to generate a gradient echo in each repetition time interval (TR); and
- acquiring echo signals.

11. Computer program of claim 10, further comprising instructions to be executed by a reconstruction unit (17) of the MR system (1), wherein execution of the instructions causes the reconstruction unit (17) to perform the following steps:
- reconstructing a morphological MR image from the acquired echo signals; and
- deriving phase-contrast angiographic information from the phase imposed on the echo signals by the velocity-encoding gradients (VE).
